# EUROPÄISCHE PATENTSCHRIFT

(11) **EP 2 583 313 B1**
(45) Veröffentlichungstag und Bekanntmachung des Hinweises auf die Patenterteilung: **02.03.2016**
(21) Anmeldenummer: 11726349.1
(22) Anmeldetag: 16.06.2011
(51) Int. Cl.: H01L 31/18

(54) **VERFAHREN ZUR ERZEUGUNG EINER SELEKTIVEN DOTIERSTRUKTUR IN EINEM HALBLEITERSUBSTRAT ZUR HERSTELLUNG EINER PHOTOVOLTAISCHEN SOLARZELLE**
METHOD FOR PRODUCING A SELECTIVE DOPING STRUCTURE IN A SEMICONDUCTOR SUBSTRATE IN ORDER TO PRODUCE A PHOTOVOLTAIC SOLAR CELL
PROCÉDÉ POUR PRODUIRE UNE STRUCTURE DE DOPAGE SÉLECTIVE DANS UN SUBSTRAT SEMI-CONDUCTEUR POUR LA PRODUCTION D'UNE CELLULE SOLAIRE PHOTOVOLTAÏQUE

(30) Priorität: 18.06.2010 DE 102010024308
(43) Veröffentlichungstag der Anmeldung: 24.04.2013
(73) Patentinhaber: Fraunhofer-Gesellschaft zur Förderung der angewandten Forschung e.V., 80686 München (DE); Albert-Ludwigs-Universität Freiburg, 79098 Freiburg (DE)
(72) Erfinder: JÄGER, Ulrich, 79108 Freiburg (DE); BIRO, Daniel, 79106 Freiburg (DE); VOLK, Anne-Kristin, 79110 Freiburg (DE); SEIFFE, Johannes, 79112 Freiburg (DE); MACK, Sebastian, 79102 Freiburg (DE); WOLF, Andreas, 79100 Freiburg (DE); PREU, Ralf, 79117 Freiburg (DE)
(86) Internationale Anmeldenummer: PCT/EP2011/002965
(87) Internationale Veröffentlichungsnummer: WO 2012/000612

(56) Entgegenhaltungen:
- WO-A1-2010/012062
- US-A1- 2009 020 158
- US-H1- H2 207
- KÖHLER J R ET AL: "LASER DOPED SELECTIVE EMITTERS YIELD 0.5% EFFICIENCY GAIN", 24TH EUROPEAN PHOTOVOLTAIC SOLAR ENERGY CONFERENCE,, 21. September 2009 (2009-09-21), Seiten 1847-1850, XP007919647,
- CARLSSON C ET AL: "Laser doping for selective silicon solar cell emitter", PROCEEDINGS OF THE 21ST EUROPEAN PHOTOVOLTAIC SOLAR ENERGY CONFERENCE, DRESDEN, GERMANY, 4 - 8 SEPTEMBER 2006, 4 September 2006 (2006-09-04), pages 938-940, XP040512319, ISBN: 978-3-936338-20-1
- STERK S ET AL: "HIGH EFFICIENCY (>22%) SI-SOLAR CELLS WITH OPTIMIZED EMITTER", WORLD CONFERENCE ON PHOTOVOLTAIC ENERGY. WAIKOLOA, DEC. 5 - 9, 1994; [WORLD CONFERENCE ON PHOTOVOLTAIC ENERGY], NEW YORK, IEEE, US, vol. CONF. 1, 5 December 1994 (1994-12-05) , pages 1303-1306, XP000680078, DOI: 10.1109/WCPEC.1994.520185 ISBN: 978-0-7803-1460-3
- B. E. Deal ET AL: "General Relationship for the Thermal Oxidation of Silicon", Journal of Applied Physics, vol. 36, no. 12, 1 January 1965 (1965-01-01), pages 3770-3778, XP055026206, ISSN: 0021-8979, DOI: 10.1063/1.1713945

## Beschreibung

Die Erfindung betrifft ein Verfahren zur Erzeugung einer selektiven Dotierstruktur an einem Halbleitersubstrat zur Herstellung einer photovoltaischen Solarzelle gemäß Oberbegriff des Anspruchs 1.

Eine photovoltaische Solarzelle stellt ein flächiges Halbleiterelement dar, bei dem mittels einfallender elektromagnetischer Strahlung eine Erzeugung von Elektron-Lochpaaren erzielt wird und an mindestens einem pn-Übergang eine Ladungsträgertrennung erfolgt, so dass zwischen mindestens zwei elektrischen Kontakten der Solarzelle eine elektrische Potentialdifferenz entsteht und über einen mit diesen Kontakten verbundenen externen Stromkreis elektrische Leistung von der Solarzelle abgegriffen werden kann.

Typische Solarzellen umfassen ein Halbleitersubstrat einer Basisdotierung, wobei in dem Halbleitersubstrat mindestens ein Emitterbereich einer Emitterdotierung, welche der Basisdotierung entgegengesetzt ist, ausgebildet ist, so dass sich zwischen Basis- und Emitterbereich der vorgenannte pn-Übergang ausbildet. Basis- und Emitterbereich sind jeweils durch mindestens eine metallische Kontaktstruktur zum Einsammeln und Abführen der Ladungsträger kontaktiert.

Zur Erzielung hoher Wirkungsgrade muss eine Optimierung hinsichtlich mehrerer Verlustmechanismen erfolgen: So ist zur Ausbildung eines niedrigen elektrischen Kontaktwiderstandes zwischen Metallisierung und kontaktiertem Halbleiterbereich eine hohe Dotierung vorteilhaft. Andererseits führt eine höhere Dotierung grundsätzlich zu einer höheren Rekombination von Elektron-Lochpaaren innerhalb des Halbleitersubstrates.

Es ist daher sowohl im Emitter- als auch im Basisbereich bekannt, selektive Dotierstrukturen auszubilden.

So ist beispielsweise die Ausbildung selektiver Emitterstrukturen bekannt, in dem beispielsweise auf der dem Licht zugewandten Vorderseite des Halbleitersubstrates flächig ein Emitter mit einem ersten Dotierprofil ausgebildet wird und lediglich in den Bereichen, in denen eine Kontaktierung des Emitters durch eine auf die Vorderseite der Halbleiterstruktur aufgebrachte metallische Emitterkontaktstruktur ausgebildet werden soll, wird ein zweites Emitterprofil mit einer gegenüber dem ersten Profil höheren Dotierung ausgebildet. Durch solch einen selektiven Emitter ist gewährleistet, dass bei Querleitung der Ladungsträger innerhalb des Emitterbereiches des ersten Emitterprofils eine Verringerung der Rekombination erzielt wird und andererseits aufgrund der höheren Dotierung des zweiten Dotierprofils ein geringer Kontaktwiderstand zu der metallischen Kontaktstruktur erzielt wird.

Für eine industrielle Implementierung der Herstellung selektiver Emitter wurden verschiedene Methoden vorgeschlagen: So beschreibt Haverkamp, H., et al. Minimizing the Electrical Losses on the Front Side: Development of a Selective Emitter Process from a Single Diffusion in 33rd IEEE PVSC. 2008. San Diego die Herstellung eines selektiven Emitters mittels homogener Diffusion eines Emitterbereiches, anschließender Maskierung und nasschemischem, teilweisem Rückätzen des Halbleitersubstrates. Weiterhin beschreibt Bultmann, J.H., et al. Single Step selective emitter using diffusion barriers in 16th EU PVSEC.2000. Glasgow die Erzeugung einer selektiven Emitterstruktur durch Aufbringen und Strukturieren einer halbdurchlässigen Diffusionsbarriere. Weiterhin ist in Jäger, U., et al. Selective emitter by laser doping from phosphosilicate glass in Proceedings of the 24th European Photovoltaic Solar Energy Conference. 2009. Hamburg, Germany die Erzeugung einer selektiven Emitterstruktur durch selektives Laserdotieren beschrieben.

Die vorgenannten Verfahren benötigen teilweise aufwändige und kostenintensive Maskierungsschritte oder führen zu Emitterprofilen, die aufgrund des Profilverlaufs noch deutlich Rekombinationsverluste und damit Wirkungsgradverringerungen aufweisen.

Der vorliegenden Erfindung liegt daher die Aufgabe zugrunde, ein Verfahren zur Erzeugung einer selektiven Dotierstruktur an einem Halbleitersubstrat zur Erstellung einer photovoltaischen Solarzelle zu schaffen, welches in industriell implementierbarer und kostengünstiger Weise die Erzeugung selektiver Dotierstrukturen ermöglicht.

Gelöst ist diese Aufgabe durch ein Verfahren gemäß Anspruch 1. Vorteilhafte Ausgestaltungen des erfindungsgemäßen Verfahrens finden sich in den Ansprüchen 2 bis 14.

Das erfindungsgemäße Verfahren dient zur Erzeugung einer selektiven Dotierstruktur in einem Halbleitersubstrat zur Herstellung einer photovoltaischen Solarzelle. Die selektive Dotierstruktur wird mindestens an einer Dotierseite des Halbleitersubstrates ausgebildet, wobei an der Dotierseite mindestens ein flächiger Niedrigdotierbereich eines ersten Dotierprofils in dem Halbleitersubstrat erzeugt und innerhalb des ersten Niedrigdotierbereiches mindestens ein lokaler Hochdotierbereich eines zweiten Dotierprofils erzeugt wird. Der Niedrigdotierbereich und der Hochdotierbereich werden hierbei mit demselben Dotierungstyp ausgebildet, wobei der Hochdotierbereich einen niedrigeren Querleitungswiderstand aufweist, als der Niedrigdotierbereich. Dotierungstypen sind hierbei die n-Dotierung und die hierzu entgegengesetzte p-Dotierung. Die Dotierseite ist die Vorder- oder Rückseite des Halbleitersubstrates.

Wesentlich ist, dass das erfindungsgemäße Verfahren folgende Verfahrensschritte umfasst:
In einem Verfahrensschritt A wird eine Dotierstoff enthaltende Dotierschicht auf die Dotierseite des Halbleitersubstrates aufgebracht.

In einem Verfahrensschritt B erfolgt ein lokales Erhitzen eines Schmelzbereiches der Dotierschicht und eines unterhalb der Dotierschicht liegenden Schmelzbereiches des Halbleitersubstrates, derart, dass sich in einem lokalem Bereich kurzzeitig eine Schmelzmischung aus zumindest dem Schmelzbereich, der Dotierschicht und dem Schmelzbereich des Halbleitersubstrates bildet, wobei durch Flüssig-flüssig-Diffusion Dotierstoff aus der Dotierschicht in das aufgeschmolzene Halbleitersubstrat diffundiert, so dass nach Erstarren der Schmelzmischung der Hochdotierungsbereich erzeugt ist.

In einem Verfahrensschritt C erfolgt das Erzeugen des flächigen Niedrigdotierbereiches, in dem das Halbleitersubstrat global erwärmt wird, derart, dass Dotierstoff aus der Dotierschicht in das Halbleitersubstrat diffundiert.

In einem Verfahrensschritt D wird die Dotierschicht entfernt.

Weiterhin wird in einem Verfahrensschritt E eine Schicht des Halbleitersubstrates an der Dotierseite entfernt und/oder umgewandelt. Hierbei wird in einem Verfahrensschritt E1 ein oberflächennaher Teil des Niedrigdotierungsbereiches und des Hochdotierungsbereiches entfernt, wobei eine Schicht mit einer Dicke im Bereich 50 nm bis 200 nm entfernt wird.

Die vorgenannten Verfahrensschritte A bis E werden hierbei in der Abfolge A, B, C, D, E oder A, C, B, D, E ausgeführt, wobei es jeweils im Rahmen der Erfindung liegt, gegebenenfalls weitere Zwischenschritte zwischenzuschalten.

Mit dem erfindungsgemäßen Verfahren wird in kostengünstiger, industriell implementierbarer Weise eine selektive Dotierstruktur erzielt. Einerseits wird durch die Dotierschicht, welche in Verfahrensschritt C durch globale Erwärmung des Halbleitersubstrates den flächigen Emitterbereich niedriger Dotierung erzeugt und in Verfahrensschritt B durch lokales Erhitzen den oder die Hochdotierungsbereiche erzeugt, in einfacher Weise ein selektives Dotierprofil erstellt, ohne dass hierfür kostenintensive Maskierungsschritte notwendig wären. Dies ist insbesondere darin begründet, dass in Verfahrensschritt C die thermische Diffusion aus der Dotierschicht in das Halbleitersubstrat wesentlich langsamer erfolgt, verglichen mit der lokalen Flüssig-flüssig-Diffusion in den temporär aufgeschmolzenen lokalen Bereichen in Verfahrensschritt B. Bereits durch die unterschiedlichen Diffusionsmechanismen ist gewährleistet, dass in Verfahrensschritt C ein Dotierbereich mit niedrigerer Dotierung erzeugt wird, verglichen mit den in Verfahrensschritt B erzeugten Dotierbereichen.

Weiterhin ist wesentlich, dass in Verfahrensschritt E an der Dotierseite des Halbleitersubstrates eine Schicht mit einer Dicke im Bereich 50 nm bis 200 nm entfernt wird entfernt. Diese ist in der Erkenntnis des Anmelders begründet, dass aufgrund der zuvor genannten unterschiedlichen Diffusionsvorgänge auch unterschiedliche Dotierprofile, d. h. unterschiedliche Verläufe der Dotierkonzentration, ausgehend von der Oberfläche des Halbleitersubstrates in eine Richtung senkrecht zur Oberfläche des Halbleitersubstrates entstehen:
In Verfahrensschritt C entstehen typischerweise so genannte "kink and tail" Dotierprofile, d. h. Dotierprofile, die in einem oberflächennahen Bereich ein sehr hohe Dotierkonzentration aufweisen, anschließend einen starken Abfall und schließlich einen flacheren Verlauf. Dies ist an sich bekannt und beispielsweise in Bentzen, A. et al. High concentration in-diffusion of phosphorus in Si from a spray-on source, Journal of Applied Physics, 99 (2006) p. 064502-1-8 beschrieben. Ein solches Dotierprofil entsteht insbesondere bei thermischem Erzeugen des Emitters aus einer unerschöpflichen Quelle, insbesondere bei Verwendung von Phosphor als Dotierstoff.

Bei der Flüssig-flüssig-Diffusion in Verfahrensschritt B entsteht hingegen ein Dotierprofil, dass annähernd einem Gaußschen Dotierprofil entspricht, d. h. ausgehend von der Oberfläche fällt die Dotierkonzentration stetig, jedoch wesentlich langsamer, verglichen mit einem kink and tail-Profil ab.

Wird nun in Verfahrensschritt E an der Oberfläche der Dotierseite des Halbleitersubstrates eine Schicht entfernt, so führt dies im Niedrigdotierbereich zu einer erheblichen Senkung der Oberflächenkonzentration des Dotierstoffes, da der hochdotierte, oberflächennahe Bereich des kink and tail-Profils ganz oder teilweise abgetragen wird. An dem oder den in Verfahrensschritt B erzeugten lokalen Hochdotierungsbereichen liegt hingegen wie zuvor erwähnt, zumindest näherungsweise ein Gaußsches Dotierprofil vor, d. h. das Entfernen der Schicht in Verfahrensschritt E führt nur zu einer vergleichsweise geringen Verringerung der Oberflächendotierkonzentration. Weiterhin sind diese Effekte mit dem erfindungsgemäßen Verfahren erzielbar, ohne dass Maskierungsschritte hierfür notwendig sind.

Im Ergebnis wird somit in den Niedrigdotierbereichen die Oberflächendotierkonzentration in Verfahrensschritt E erheblich gesenkt, so dass in diesen Bereichen die Rekombinationsaktivität, insbesondere aufgrund von Auger-Rekombination und beispielsweise Phosphor-Präzipitaten erheblich gesenkt und damit Wirkungsgradverluste vermieden werden. Dieser Effekt ist beispielsweise in Nguyen, V. et al., Analysis of Screen-Printed Silicon Solar Cell Emitters in Proceedings 24th EU PVSEC, Hamburg, 2009 beschrieben.

In den Hochdotierbereichen erfolgt hingegen keine oder nur eine vernachlässigbar geringe Absenkung der Oberflächendotierkonzentration in Verfahrensschritt E, so dass nach wie vor ein geringer Kontaktwiderstand zwischen Halbleitersubstrat und metallischer Kontaktstruktur aufgrund der hohen Oberflächendotierkonzentration gewährleistet ist.

Desweiteren kann durch die Entfernung der oberflächennahen Schicht im Schritt E1 oberflächennahe Defekte, wie etwa Präzipitate von Dotierstoff, abgetragen werden und somit deren Beitrag zur Rekombination eliminiert werden.

Mit dem erfindungsgemäßen Verfahren ist somit in optimierter Weise eine selektive Dotierstruktur herstellbar, die einerseits kostengünstig in industrielle Fertigungsprozesse eingebunden werden kann, insbesondere aufgrund der Reduzierung oder Vermeidung von Maskierungsschritten, und andererseits einen hohen Gesamtwirkungsgrad der fertigen Solarzelle ermöglicht, insbesondere, da in Verfahrensschritt E in den Niedrigdotierbereichen die Oberflächendotierkonzentration erheblich gesenkt wird, in den Hochdotierungsbereichen jedoch nicht.

Die Ausführung der Verfahrensschritte A bis E des erfindungsgemäßen Verfahrens erfolgt ohne Zwischenschaltung von Maskierungsschritten, um Kosten einzusparen.

Dies unterscheidet weiterhin das erfindungsgemäße Verfahren von vorbekannten Verfahren zur Erzeugung selektiver Dotierstrukturen, in denen mehrere kostenintensive Maskierungsschritte notwendig sind.

Vorzugsweise werden Hoch- und Niederdotierbereich derart ausgebildet, dass der Hochdotierbereich eine gleiche oder höhere Oberflächendotierkonzentration aufweist als der Niedrigdotierbereich.

Das lokale Erhitzen in Verfahrensschritt B erfolgt vorzugsweise mittels eines Lasers. Hierbei kann auf an sich bekannte Verfahren zur Laserdotierung zurückgegriffen werden, wie beispielsweise in Jäger, U., et al. Selective emitter by laser doping from phosphosilicate glass in Proceedings of the 24th European Photovoltaic Solar Energy Conference. 2009. Hamburg, Germany beschrieben.

Der Laserdotierprozess wird vorzugsweise mit gepulsten Lasern durchgeführt, die eine Wellenlänge in einem Bereich von 190 nm bis 1100 nm haben. Als Pulslängen sind Längen von 1 ps bis 5 µs in Abhängigkeit der gewählten Repetitionsrate vorteilhaft. Vorzugsweise wird ein Laser mit einer Wellenlänge von 343, 355, 515 oder 532 nm bei Pulslängen im Bereich von 10-500 ns gewählt. Es ist ebenfalls möglich, den Dotierprozess mit einem Laser im Dauerstrichbetrieb ("cw" = continuous wave) oder einem cw-Laser im moduliertem Betrieb in den genannten Wellenlängen durchzuführen.

Vorzugsweise wird in Verfahrensschritt E eine Schicht mit einer vorgegebenen Dicke abgetragen so dass die Oberflächendotierkonzentration des Niedrigdotierbereiches an der Dotierseite nach Abtragen der Schicht weniger als 4x10²⁰ cm⁻³, bevorzugt weniger als 2x10²⁰ cm⁻³, insbesondere bevorzugt weniger als 1x10²⁰ cm⁻³, weiter bevorzugt weniger als 5x10¹⁹ cm⁻³ beträgt. Hierdurch ist eine erhebliche Verringerung insbesondere der Auger-Rekombination und gegebenenfalls das Entfernen unerwünschter Phosphor-Präzipitate im Niedrigdotierbereich gewährleistet.

Untersuchungen des Anmelders haben ergeben, dass bei Ausgestaltung des erfindungsgemäßen Verfahrens durch Abtragen einer Schicht in Verfahrensschritt E1 eine Schicht mit einer Dicke zwischen 50 nm und 200 nm abgetragen wird.

Hierdurch ist für die gängigen Prozessparameter, insbesondere die gängigen Dotierprofile eine ausreichende Absenkung der Oberflächendotierkonzentration in den Niedrigdotierbereichen zur Verringerung der Auger-Rekombination gewährleistet.

Erfindungsgemäß erfolgt in Verfahrensschritt E ein Entfernen einer Schicht des Halbleitersubstrates, d. h. einer kristallinen Struktur des kristallinen Halbleitersubstrates. Die steht im Gegensatz beispielsweise zu vorbekannten Prozessen, bei denen nach einem Diffusionsschritt so genanntes PSG-Glas abgenommen wird, da bei diesen Schritten lediglich amorphe Strukturen abgenommen bzw. umgewandelt werden. Es erfolgt in Verfahrensschritt E eine Abnahme einer Schicht des Halbleitersubstrates mit einer Dicke im Bereich 50 nm bis 200 nm.

In Verfahrensschritt D erfolgt vorzugsweise ein flächiges Entfernen der Dotierschicht. Insbesondere ist es vorteilhaft, die gesamte Dotierschicht in Verfahrensschritt D zu entfernen.

Die in Verfahrensschritt A aufgebrachte Dotierschicht weist vorzugsweise eine Dicke zwischen 10 nm und 1 µm, bevorzugt zwischen 10 nm und 500 nm, im weiteren bevorzugt zwischen 10 nm und 100 nm auf. Hierdurch ist gewährleistet, dass ausreichend Dotierstoff für die nachfolgenden Dotierprozesse vorliegt, insbesondere eine unendliche Dotierstoffquelle für die Erzeugung des Niederdotierbereiches.

Die in Verfahrensschritt A aufzubringende Dotierschicht wird vorzugsweise durch eine der folgenden Verfahren erzeugt: Chemische Gasphasenabscheidung "chemical vapour deposition" (CVD); Diese weist den Vorteil guter Homogenität und Prozesskontrolle auf; Physikalische Gasphasenabscheidung (PVD) oder Kathodenzerstäubung; Diese weisen ebenfalls Vorteil guter Homogenität und Prozesskontrolle auf; Aufbringen eines flüssigen Dotierstoffes durch Sprühen oder Aufspinnen oder Aufdrucken (z.B. verdünnte Phosphorsäure); Dies weist den Vorteil auf, dass es sich um eine sehr kostengünstige Methode handelt; Aufwachsen von dotierten Silikatgläsern im Rohrofen (z.B. Phosphorsilikatglas (PSG) oder Borsilikatglas (BSG)); Dies weist den Vorteil auf, dass die derart erzeugten Schichten eine sehr hohe Qualität aufweisen.

Weiterhin ist es vorteilhaft, dass die Dotierschicht Dotierstoff in einer Konzentration von mindestens 1 Gewichtsprozent, bevorzugt mindestens 4 Gewichtsprozent; im weiteren bevorzugt im Bereich von 6 Gewichtsprozent bis 10 Gewichtsprozent aufweist. Hierdurch ist gewährleistet, dass ausreichend Dotierstoff für die nachfolgenden Dotierprozesse vorliegt, insbesondere eine unendliche Dotierstoffquelle für die Erzeugung des Niederdotierbereiches.

In einer vorteilhaften Ausführung des Verfahrens werden die Verfahrensschritt in der Reihenfolge A, C, B, D, E durchgeführt und die Schritte A und C werden direkt nacheinander, ohne Zwischenschaltung von Zwischenschritten und in einer Anlage durchgeführt. Untersuchungen des Anmelders haben ergeben, dass dies vorteilhaft für die thermische Emitterbildung insbesondere bei Verwendung von Rohröfen ist. Vorzugsweise werden Verfahrensschritte A und C gleichzeitig durchgeführt.

Vorzugsweise wird bei dem erfindungsgemäßen Verfahren nach Verfahrensschritt E in einem Verfahrensschritt F eine Schutzschicht auf die Dotierseite des Halbleitersubstrates aufgebracht. Hierdurch wird eine Beeinträchtigung und insbesondere Verschlechterung der Rekombihationsrate dieser Oberfläche vermieden. Vorzugsweise ist die Schutzschicht gleichzeitig als Antireflexschicht zur Erhöhung der Lichteinkopplung ausgebildet. Insbesondere ist eine Ausgestaltung der Schutzschicht als Siliziumnitridschicht oder Siliziumoxidschicht vorteilhaft. Die Dicke der Schutzschicht liegt vorzugsweise im Bereich 50 bis 120 nm. Der optische Brechungsindex der Schichten liegt dabei vorzugsweise in einem Bereich von 1.3 bis 2.5. Es liegt auch im Rahmen der Erfindung, dass mehrere Schichten als Schutz- und Antireflexschicht abgeschieden werden.

In Verfahrensschritt A wird die Dotierschicht vorzugsweise die gesamte Dotierseite des Halbleitersubstrates bedeckend aufgebracht.

Wie zuvor ausgeführt, wird bei dem erfindungsgemäßen Verfahren in einem Verfahrensschritt E1 ein oberflächennaher Teil des Niedrigdotierungsbereiches und des Hochdotierungsbereiches entfernt.

Beim erfindungsgemäßen Verfahren wird in Verfahrensschritt E Verfahrensschritt E1 durchgeführt, d. h. es wird eine Schicht des Halbleitersubstrates an der Dotierseite entfernt. Dies weist den Vorteil auf, dass eine maskierungsfreie Bearbeitung des Substrates durchgeführt werden kann. Vorzugsweise wird die Schicht mittels nasschemischen Ätzens entfernt, insbesondere vorzugsweise mittels einer Mischung aus Fluorwasserstoffsäure (HF), Salpetersäure (HNO₃), Essigsäure (CH₃COOH) und Wasser (H₂O). Das Entfernen erfolgt vorzugsweise folgende Verfahrensschritte umfassend: Durch eine Ätzlösung wird eine Schicht von porösem Silizium gebildet, welche dann in einem kurzen zweiten Ätzschritt durch in Wasser verdünntes Kaliumhydroxid (KOH) abgenommen wird. Anschließend wird ein Spülen in Wasser (H₂O) vorgenommen.

Des Weiteren kann das Entfernen der oberflächennahen Schicht durch eine, oder mehrere hintereinander ausgeführte SC1/SC2 Reinigungen erfolgen. Ebenso sind Flusssäurehaltige Lösungen möglich.

Des Weiteren kann das Entfernen der oberflächennahen Schicht durch Flusssäure (HF) unter Zugabe von Tensiden erfolgen, vorzugsweise unter Verwendung höher konzentrierter Flusssäure.

Des Weiteren kann das Entfernen der oberflächennahen Schicht durch Phosphorsäure (H₃PO₄) erfolgen.

Des Weiteren kann das Entfernen der oberflächennahen Schicht durch Schwefelsäure (H₂SO₄) oder in H₂O verdünnte H₂SO₄ erfolgen.

Des Weiteren kann das Entfernen der oberflächennahen Schicht durch in H₂O gelöstes Kaliumhydroxid (KOH) erfolgen.

Des Weiteren kann das Entfernen der oberflächennahen Schicht durch in H₂O gelöstes Natriumhypochlorid (NaOCl) erfolgen.

In einer weiteren vorzugsweisen Ausführungsform des erfindungsgemäßen Verfahrens wird in Verfahrensschritt E1 die Schichtabnahme mittels plasmaunterstütztem Ätzen durchgeführt.

In einer weiteren Ausführung, die ausserhalb des Schutzumfangs der Ansprüche liegt, wird in Verfahrensschritt E2 die Schichtumwandlung mittels thermischer Oxidation vorgenommen. Durch thermisches Aufwachsen einer Siliziumdioxidschicht auf die Dotierseite des Halbleitersubstrates erfolgt die Umwandlung einer oberflächennahen Schicht des Halbleitersubstrates in Siliziumdioxid. Hierdurch wird zwar die absolute Dotierkonzentration im Niedrigdotier- und Hochdotierbereich nicht verändert. Für die elektrische Eigenschaft der Solarzelle und insbesondere die Verlustmechanismen im Niedrigdotierbereich ist jedoch die Dotierkonzentration in dem elektrisch aktiven Bereich des Halbleitersubstrates an der Dotierseite entscheidend. Die Schichtumwandlung in eine elektrisch nicht aktive Schicht führt somit ebenso zu einer Absenkung der elektrisch aktiven Oberflächendotierkonzentration im Niedrigdotierbereich, so dass wie vorangehend ausgeführt insbesondere eine Verringerung der Auger-Rekombination und gegebenenfalls Auflösung von Phosphor-Präzipitaten erzielt wird.

Die Ausbildung des thermischen Oxids in Verfahrensschritt E2 erfolgt vorzugsweise folgende Verfahrensschritte umfassen: Ein thermisches Oxid bildet sich, wenn das Halbleitersubstrat hohen Temperaturen, vorzugsweise Temperaturen oberhalb von 650 °C und einer oxidierenden Atmosphäre ausgesetzt wird. Diese Atmosphäre besteht vorzugsweise aus Wasserdampf oder Sauerstoffgas oder einer Kombination von beidem. Vorteilhaft ist die Beimischung chlorhaltiger Chemikalien. Ebenso liegt die Beimischung weiterer Gase, wie beispielsweise von Stickstoff oder einem anderen Inertgasen zum Verdünnen der Gasatmosphäre im Rahmen der Erfindung. Weiterhin kann das thermische Oxid unter erhöhtem Druck (größer 1 Bar) erzeugt werden, um die für die gewünschte Dicke notwendige Oxidationszeit herabzusetzen. Denn die Oxidationsrate nimmt mit höherem Druck zu.

Desweiteren kann durch die Entfernung der oberflächennahen Schicht im Schritt E1 oberflächennahe Defekte, wie etwa Präzipitate von Dotierstoff, abgetragen werden und somit deren Beitrag zur Rekombination eliminiert werden.

In einer weiteren Ausführungsform des erfindungsgemäßen Verfahrens wird die Umwandlung einer Schicht in ein Oxid nasschemisch vorgenommen. Diese umgewandelte Schicht wird anschließend abgenommen, vorzugsweise mit Flusssäure.

Das erfindungsgemäße Verfahren ist insbesondere zur Ausbildung eines selektiven Emitters und hierbei insbesondere eines selektiven Emitters an der zur Lichteinkopplung ausgebildeten Vorderseite des Halbleitersubstrates geeignet. In diesem Fall weisen Niedrig- und Hochdotierbereich somit einen Emitterdotierungstyp auf, der entgegengesetzt zu einem Basisdotierungstyp des Halbleitersubstrates ist. Dies ist für beliebige Dotiertypkombinationen möglich, d. h. zur Ausbildung eines n-dotierten Emitters auf einer p-dotierten Basis oder umgekehrt.

Ebenso ist das erfindungsgemäße Verfahren jedoch auch geeignet, selektive Dotierungen des Basisdotierungstyps zu erzeugen: Hier werden Niedrig- und Hochdotierbereich des Basisdotierungstyps erzeugt, wobei der Niedrigdotierbereich eine höhere Dotierkonzentration gegenüber der Basisdotierkonzentration des Halbleitersubstrates aufweist und der Hochdotierungsbereich wiederum eine höhere Dotierkonzentration gegenüber dem Niedrigdotierbereich aufweist. Eine solche Ausgestaltung ist insbesondere zur Ausbildung einer Rückseite einer Solarzelle mit hoher elektrischer Güte und niedrigen Kontaktwiderstand vorteilhaft.

Die Passivierungsmechanismen solcher Dotierbereiche des Basisdotierungstyps sind als so genanntes "back surface field" bekannt.

Eine solche Ausgestaltung ist ebenfalls zur Ausbildung selektiver Dotierung für eine Vorderseite mit hoher elektrischer Güte einer Solarzelle vorteilhaft.

Die Passivierungsmechanismen solcher Dotierbereiche des Basisdotierungstyps sind als so genanntes "front surface field" bekannt.

Die Dotierseite ist vorzugsweise diejenige Seite der Solarzelle, an welcher ein selektiver Emitter ausgebildet wird.

Die Dotierseite ist vorzugsweise diejenige Seite der Solarzelle, welche bei Betrieb der einfallenden elektromagnetischen Strahlung zugewandt ist.

Vorzugsweise werden der oder die Hochdotierungsbereiche diejenigen Bereiche der Dotierseite des Halbleitersubstrates bedeckend ausgebildet, an welchen in späteren Verfahrensschritten eine metallische Kontaktstruktur auf die Dotierseite des Halbleitersubstrates aufgebracht wird. Hierdurch wird, wie zuvor ausgeführt, ein niedriger Kontaktwiderstand zwischen metallischer Kontaktstruktur und Halbleitersubstrat gewährleistet.

In Verfahrensschritt B erfolgt vorzugsweise eine lokale Erwärmung des Halbleitersubstrates auf mindestens 1410 °C, um ein lokales Aufschmelzen und die vorgenannte Flüssig-flüssig-Diffusion zu gewährleisten.

Zur Verfahrensvereinfachung und Kostenreduzierung werden vorzugsweise in den Verfahrensschritten B und C die Dotierbereiche derart erzeugt, dass der Niedrigdotierbereich die Dotierseite des Halbleitersubstrates vollständig bedeckend aufgebracht wird und eine Vielzahl von Hochdotierungsbereichen ausgebildet werden. Insbesondere die Ausbildung des Niedrigdotierbereiches, welche die Dotierseite vollständig bedeckt, ist verfahrenstechnisch einfach durchführbar, insbesondere dadurch, dass in Verfahrensschritt A die Dotierschicht die Dotierseite des Halbleitersubstrates vollständig bedeckend aufgebracht wird. Hoch- und Niedrigdotierbereich werden vorzugsweise parallel zur Oberfläche des Halbleitersubstrates an der Dotierseite ausgebildet.

Ebenso ist die in Verfahrenschritt E entfernte Schicht an der Dotierseite des Halbleitersubstrates vorzugsweise eine parallel zur Dotierseite liegende Schicht.

Das erfindungsgemäße Verfahren ist insbesondere zur Ausbildung selektiver Dotierstrukturen bei Silizium-Solarzellen geeignet, gleichermaßen bei Solarzellen auf monokristallinem, multikristallinem oder mikrokristallinem Siliziumwafern basierend.

Vorzugsweise erfolgt in Verfahrensschritt A das Aufbringen der Dotierschicht, welche zumindest Phosphor als Dotierstoff, bevorzugt ausschließlich Phosphor als Dotierstoff enthält.

Weitere Merkmale und bevorzugte Ausführungsformen der Erfindung ergeben sich aus den Figuren und der Figurenbeschreibung. Dabei zeigt:
- Figur 1: ein Ausführungsbeispiel des erfindungsgemäßen Verfahrens, bei dem in einem Verfahrensschritt E1 eine Schicht an der Dotierseite des Halbleitersubstrates entfernt wird und
- Figur 2: ein weiteres Ausführungsbeispiel, das nicht Teil der Erfindung ist, bei dem in einem Verfahrensschritt E2 eine Schicht des Halbleitersubstrates an der Dotierseite in eine elektrisch nicht leitende Schicht umgewandelt wird.

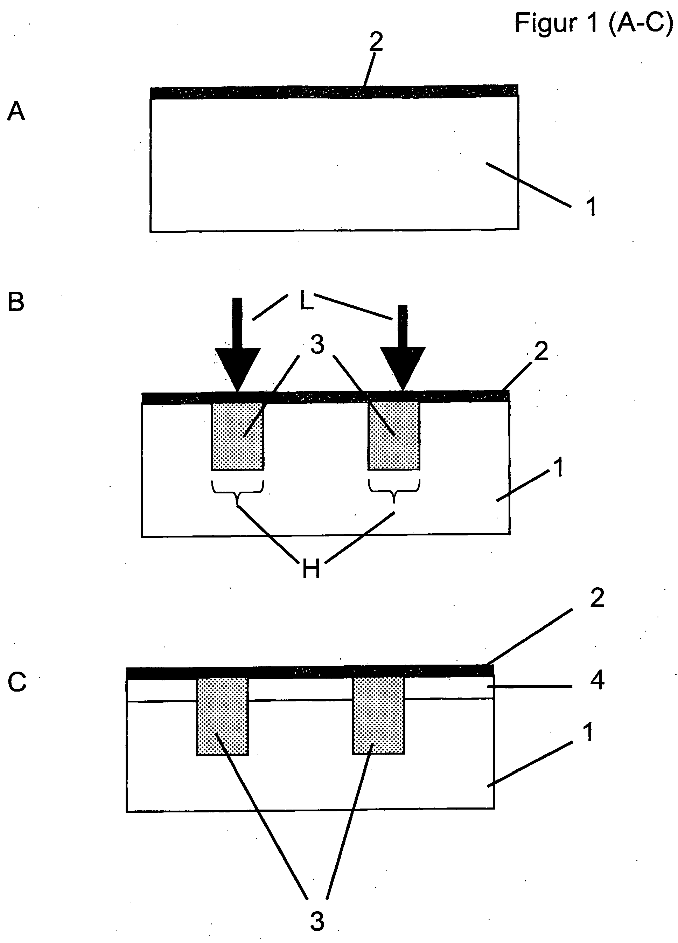

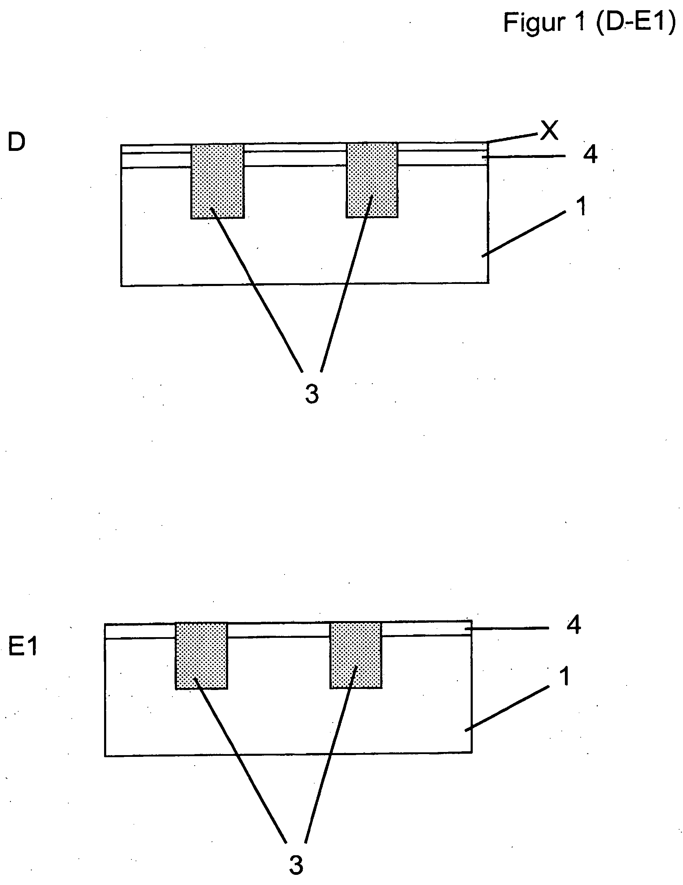

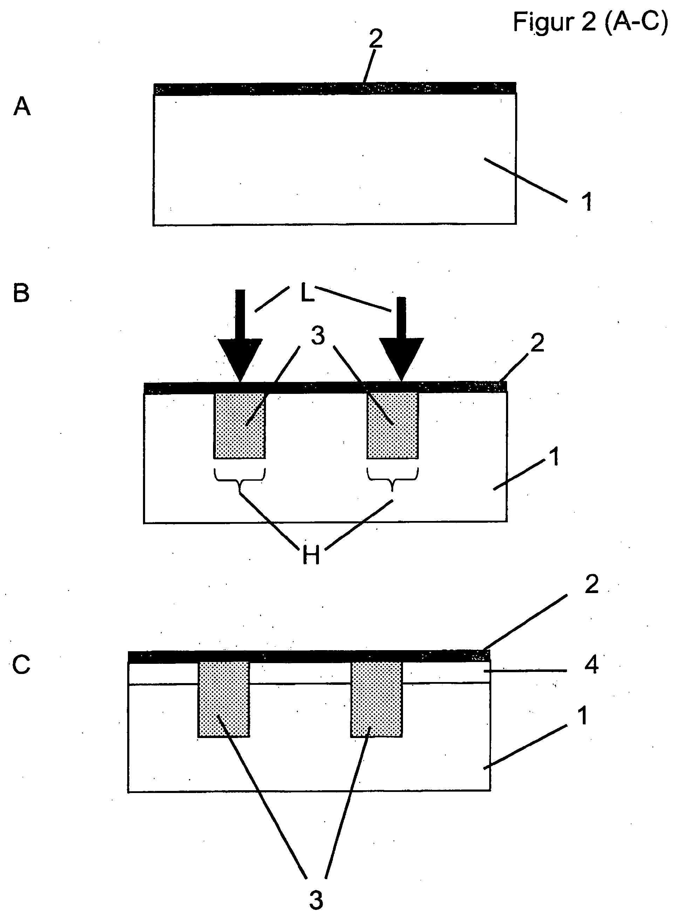

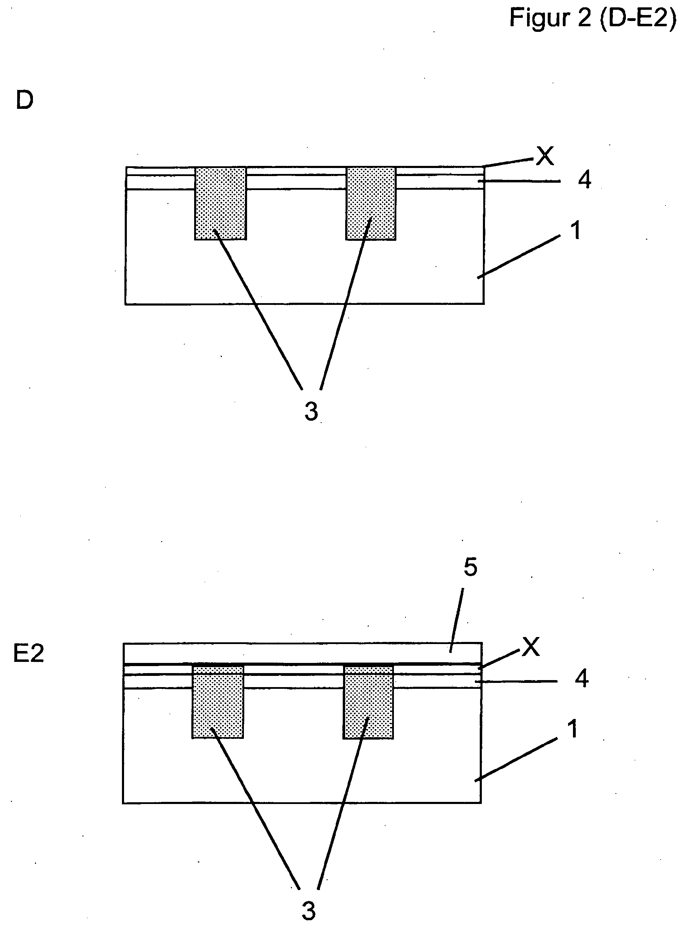

In den Figuren 1 und 2 sind jeweils Teilausschnitte eines als Siliziumwafer ausgebildeten Halbleitersubstrates 1 dargestellt. Das Halbleitersubstrat weist eine p-Dotierung von N_{A} = 1.5E16 cm⁻³ auf und setzt sich jeweils nach rechts und links fort. Das Halbleitersubstrat 1 besitzt eine Dicke von 200 µm und ist etwa quadratisch ausgebildet bei einer Kantenlänge von 15 cm.

Gleiche Bezugszeichen in den Figuren 1 und 2 bezeichnen gleiche Elemente.

In dem in Figur 1 dargestellten ersten Ausführungsbeispiel des erfindungsgemäßen Verfahrens erfolgt in einem Verfahrensschritt A ein Aufbringen einer Dotierschicht 2 auf die oben liegende Vorderseite des Halbleitersubstrates 1, welche bei der herzustellenden Solarzelle zur Lichteinkopplung ausgebildet serin wird.

Die Dotierschicht 2 wird mittels chemischer Gasphasenabscheidung ("Chemical Vapour Deposition", CVD) abgeschieden und besteht aus SiOₓ:P (Phosphorsilikatglass "PSG") mit dem Dotierstoff Phosphor in einer Konzentration von 4-8 Gewichtsprozent.

In einem Verfahrensschritt B wird mittels lokaler Erhitzung durch einen Laserstrahl L in einem lokalen Bereich H kurzzeitig eine Schmelzmischung aus der Dotierschicht 2 und dem Halbleitersubstrat 1 innerhalb der gestrichelt dargestellten Linie in Figur 1B erzeugt. Innerhalb der Schmelzmischung erfolgt eine Flüssig-flüssig-Diffusion des Dotierstoffes aus der Dotierschicht 2 in das Halbleitersubstrat 1, so dass nach Erstarren der Schmelzschicht ein Hochdotierbereich 3 in dem Halbleitersubstrat vorliegt, der an der Oberfläche des Halbleitersubstrates 1 eine Dotierkonzentration von etwa 4E20 cm⁻³ aufweist.

Das lokale Aufschmelzen erfolgt durch einen Laser mit einer Wellenlänge von 532 nm, wobei der Laser gepulst mit einer Pulslänge im Bereich von 10 ns bis 500 ns betrieben wird.

In einem Verfahrensschritt C erfolgt eine globale Erwärmung des Halbleitersubstrates 1 in einem Durchlaufofen auf eine Temperatur von 850 °C für eine Zeitdauer von 30 min. Hierdurch wird eine Diffusion von Dotierstoff aus der Dotierschicht 2 in das Halbleitersubstrat 1 an der Dotierseite des Halbleitersubstrates erzielt, so dass sich ein Niedrigdotierbereich 4 ausbildet. Aufgrund dieses Prozesses weist der Niedrigdotierbereich ein kink and tail-Profil auf, wie beispielsweise in Bentzen, A. et al. High concentration in-diffusion of phosphorus in Si from a spray-on source, Journal of Applied Physics, 99 (2006) p. 064502-1-8 beschrieben, mit einer Oberflächendotierkonzentration von 5E20 cm⁻³ und einem Schichtwiderstand von 50 Ohm/sq (vor dem Verfahrensschritt E).

Der Schichtwiderstand des in Verfahrensschritt B erzeugten Hochdotierbereiches 3 beträgt hingegen 20 Ohm/sq.

In einem Verfahrensschritt D wird die Dotierschicht 2 durch folgenden nasschemischen Prozess entfernt: Ätzen für weniger als 2 Minuten in 10% Flusssäure (HF) in H₂O, anschließendes Spülen in H₂O.

Anschließend erfolgt in einem Verfahrensschritt E1 ein Abtragen einer Schicht an der Dotierseite des Halbleitersubstrates 1 mit einer Dicke von 50 nm. Diese Dicke ist in Figur 1D mit X gekennzeichnet.

Das Ergebnis ist in Figur 1, E1 dargestellt. Die Schicht wird ebenfalls mittels eines nasschemischen Verfahrens abgetragen, folgende Verfahrensschritte umfassend: Durch eine Ätzlösung (Mischung aus Fluorwasserstoffsäure (HF), Salpetersäure (HNO₃), Essigsäure (CH₃COOH) und Wasser (H₂O)) wird eine Schicht von porösem Silizium gebildet, welche dann in einem kurzen zweiten Ätzschritt durch in Wasser verdünntes Kaliumhydroxid (KOH) abgenommen wird. Anschließend wird ein Spülen in Wasser (H₂O) vorgenommen.

Das Abtragen der Schicht an der Dotierseite des Halbleitersubstrates 1 in Verfahrenschritt E1 führt zu einer Verringerung der Oberflächenkonzentration des Niedrigdotierbereiches 4 von 5E20 cm⁻³ auf 2E20 cm⁻³ dadurch, dass der hochdotierte, oberflächenahe Bereich des kink and tail-Profils mit der Schicht entfernt wird. Der Schichtwiderstand des Niedrigdotierbereiches ändert sich hierdurch jedoch nur geringfügig von 20 Ohm/sq auf 25 Ohm/sq, so dass einerseits die Rekombination in dem Niedrigdotierbereich erheblich verringert wird, die Querleitfähigkeit jedoch näherungsweise unbeeinträchtigt bleibt.

In dem Hochdotierbereich 3, der aufgrund der Flüssig-flüssig-Diffusion ein in etwa gaußförmiges Dotierprofil aufweist, erfolgt durch Abtragen der Schicht in Verfahrensschritt E1 jedoch lediglich eine Verringerung der Oberflächendotierkonzentration von 4E20 cm⁻³ auf 3.8E20 cm⁻³. Hierdurch ist gewährleistet, dass nach Abtragen der Schicht bei Aufbringen einer metallischen Kontaktstruktur auf das Halbleitersubstrat in dem Hochdotierbereich 3 ein geringer Kontaktwiderstand aufgrund der hohen Oberflächendotierkonzentration gewährleistet ist.

In Figur 2 ist das weitere vorbenannte Beispiel dargestellt, wobei die Verfahrensschritte A bis D identisch zu dem ersten Ausführungsbeispiel durchgeführt werden. Anschließend erfolgt jedoch in Verfahrensschritt E2 eine Umwandlung einer Schicht an der Dotierseite des Halbleitersubstrates 1 in eine elektrisch nicht leitende Schicht. Die Umwandlung wird dadurch erzielt, dass mittels globaler Erwärmung des Halbleitersubstrates 1 in Sauerstoffgasatmosphäre oder Wasserdampfgasatmosphäre eine Siliziumschicht 5 an der Dotierseite des Halbleitersubstrates 1 ausgebildet wird, welche jedoch ebenfalls eine oberflächennahe Schicht der Dicke 10 nm (in Figur 2 mit X markiert) des Halbleitersubstrates 1 in eine Siliziumoxidschicht umwandelt. Dieser in eine Siliziumoxidschicht umgewandelte Bereich des Halbleitersubstrates 1 ist somit elektrisch inaktiv und für die Betrachtung der elektrischen Eigenschaften, insbesondere der Rekombinationsprozesse nicht relevant.

Durch die Umwandlung wird somit analog zu dem in Figur 1 beschriebenen Ausführungsbeispiel der Niedrigdotierbereich derart verändert, dass die für die elektrischen Eigenschaften relevante Oberflächendotierkonzentration des Niedrigdotierbereiches von 5E20 cm⁻³ auf 2E20 cm⁻³ gesenkt wird, wobei sich der Schichtwiderstand lediglich von 100 Ohm/sq auf 120 Ohm/sq ändert. Wie bereits zu Figur 1 ausgeführt, führt die Umwandlung der oberflächennahen Schicht des Halbleitersubstrates in eine elektrisch nicht leitende Schicht jedoch nur zu einer geringfügigen Verringerung der elektrisch relevanten Oberflächendotierkonzentration des Hochdotierbereiches 3 von 4E20 cm⁻³ auf 3.8E20 cm⁻³, so dass der Hochdotierbereich mit geringem Kontaktwiderstand durch eine metallische Kontaktstruktur kontaktierbar ist. Der zusätzliche thermische Eintrag durch den Oxidationsprozess kann zusätzlich ein Eintreiben des Emitters bewirken. Dadurch wird zusätzlich zur Umwandlung in eine isolierende Schicht, die Oberflächenkonzentration des Niedrigdotierbereichs abgesenkt.

In einem nicht dargestellten auf E2 folgenden, optionalen Verfahrensschritt wird die Siliziumoxidschicht 5 sowie der Bereich des Halbleitersubstrates 1, der in einer Siliziumoxidschicht umgewandelt wurde, mittels nasschemischen Ätzens entfernt. Das Entfernen umfasst folgende Verfahrensschritte: Ätzen für weniger als 10 min in 2-10% Flusssäure (HF) in H₂O, anschließendes Spülen in H₂O.

## Patentansprüche

1. Verfahren zur Erzeugung einer selektiven Dotierstruktur in einem Halbleitersubstrat (1) zur Herstellung einer photovoltaischen Solarzelle, wobei die selektive Dotierstruktur mindestens an einer Dotierseite des Halbleitersubstrates ausgebildet wird, wobei an der Dotierseite mindestens ein flächiger Niedrigdotierbereich (4) eines ersten Dotierprofils in dem Halbleitersubstrat (1) erzeugt und innerhalb des ersten Niedrigdotierbereiches mindestens ein lokaler Hochdotierbereich (3) eines zweiten Dotierprofils erzeugt wird,
wobei der Niedrigdotierbereich (4) und der Hochdotierbereich (3) mit demselben Dotierungstyp ausgebildet werden und der Hochdotierbereich einen niedrigeren Querleitungswiderstand aufweist als der Niedrigdotierbereich (4),
wobei das Verfahren folgende Verfahrensschritte umfasst:
A Aufbringen einer Dotierstoff enthaltenden Dotierschicht (2) auf die Dotierseite des Halbleitersubstrates,
B lokales Erhitzen eines Schmelzbereiches der Dotierschicht (2) und eines unterhalb der Dotierschicht (2) liegenden Schmelzbereiches des Halbleitersubstrates, derart, dass sich in einem lokalen Bereich kurzzeitig eine Schmelzmischung aus zumindest dem Schmelzbereich der Dotierschicht (2) und dem Schmelzbereich des Halbleitersubstrates bildet, wobei mittels Flüssig-flüssig Diffusion Dotierstoff aus der Dotierschicht (2) in das aufgeschmolzene Halbleitersubstrat (1) diffundiert, so dass nach Erstarren der Schmelzmischung der Hochdotierbereich erzeugt ist,
C Erzeugen des flächigen Niedrigdotierbereiches (4), indem das Halbleitersubstrat (1) global erwärmt wird, derart, dass Dotierstoff aus der Dotierschicht (2) in das Halbleitersubstrat (1) diffundiert,
D Entfernen der Dotierschicht (2),
**dadurch gekennzeichnet,**
**dass** das Verfahren weiterhin folgenden Verfahrensschritt umfasst:
E Entfernen einer Schicht des Halbleitersubstrates an der Dotierseite, derart, dass in einem Verfahrensschritt E1 ein oberflächennaher Teil des Niedrigdotierungsbereiches (4) und des Hochdotierungsbereiches (3) entfernt wird,
wobei die Verfahrensschritte in der Abfolge A,B,C,D,E oder A,C,B,D,E ausgeführt werden, mit oder ohne Zwischenschaltung weiterer Zwischenschritte,
**dass** die Verfahrensschritte A bis E ohne Zwischenschaltung von Maskierungsschritten ausgeführt werden und
**dass** in Verfahrensschritt E eine Schicht mit einer Dicke im Bereich 50 nm bis 200 nm entfernt wird.

2. Verfahren nach Anspruch 1,
**dadurch gekennzeichnet,**
**dass** in der Verfahrensabfolge A,C,B,D,E die Verfahrensschritte A und C direkt nacheinander erfolgen oder dass die Verfahrensschritte A und C gleichzeitig erfolgen.

3. Verfahren nach einem der vorangegangenen Ansprüche,
**dadurch gekennzeichnet,**
**dass** in Verfahrensschritt E eine Schicht mit einer vorgegebenen Dicke im Bereich 50 nm bis 200nm abgetragen wird, so dass die Oberflächendotierkonzentration des Niedrigdotierbereiches (4) an der Dotierseite weniger als 4x10²⁰ cm⁻³, bevorzugt weniger als 2x10²⁰ cm⁻³, insbesondere bevorzugt weniger als 1x10²⁰ cm⁻³, weiterhin bevorzugt weniger als 5x10¹⁹ cm⁻³ beträgt.

4. Verfahren nach einem der vorangegangenen Ansprüche,
**dadurch gekennzeichnet,**
**dass** der Hochdotierbereich (3) eine gleiche oder höhere Oberflächendotierkonzentration aufweist als der Niedrigdotierbereich (4).

5. Verfahren nach einem der vorangegangenen Ansprüche,
**dadurch gekennzeichnet,**
**dass** die Dotierschicht (2) eine Dicke zwischen 10 nm und 1 µm, bevorzugt zwischen 10 nm und 500 nm, im Weiteren bevorzugt zwischen 10 nm und 100 nm aufweist.

6. Verfahren nach einem der vorangegangenen Ansprüche,
**dadurch gekennzeichnet,**
**dass** die Dotierschicht (2) Dotierstoff in einer Konzentration von mindestens 1 Gewichtsprozent, bevorzugt mindestens 4 Gewichtsprozent, im weiteren bevorzugt im Bereich von 6 Gewichtsprozent bis 10 Gewichtsprozent enthaltend aufgebracht wird.

7. Verfahren nach einem der vorangegangenen Ansprüche,
**dadurch gekennzeichnet,**
**dass** in einem Verfahrensschritt F eine Schutzschicht auf die Dotierseite des Halbleitersubstrates aufgebracht wird, vorzugsweise mehrere Schutzschichten.

8. Verfahren nach einem der vorangegangenen Ansprüche,
**dadurch gekennzeichnet,**
**dass** in Verfahrensschritt A die Dotierschicht (2) die gesamte Dotierseite des Halbleitersubstrates bedeckend aufgebracht wird.

9. Verfahren nach einem der vorangegangenen Ansprüche,
**dadurch gekennzeichnet,**
**dass** in Verfahrensschritt E1 die Schicht mittels nasschemischen Ätzens entfernt wird, vorzugsweise mittels Flusssäure (HF), insbesondere mittels einer Mischung aus Fluorwasserstoffsäure (HF), Salpetersäure (HNO3), Essigsäure (CH3COOH) und Wasser (H2O) sowie anschließendem Entfernen der sich bildenden Schicht mittels Kaliumhydroxid.

10. Verfahren nach einem der vorangegangenen Ansprüche,
**dadurch gekennzeichnet,**
**dass** in Verfahrensschritt E das Entfernen derart erfolgt, dass eine Schichtumwandlung mittels thermischer Oxidation oder mittels chemischer Oxidation erfolgt und
**dass** die umgewandelte Schicht anschließend abgetragen wird, vorzugsweise durch einen nasschemischen Ätzprozess, insbesondere mittels Flusssäure (HF).

11. Verfahren nach einem der vorangegangenen Ansprüche,
**dadurch gekennzeichnet,**
**dass** in Verfahrensschritt B das lokale Aufschmelzen in einem im Wesentlichen linienförmigen Bereich erfolgt.

12. Verfahren nach einem der vorangegangenen Ansprüche,
**dadurch gekennzeichnet,**
**dass** der Hochdotierungsbereich diejenigen Bereiche der Dotierseite bedeckend ausgebildet ist, an welchen in späteren Verfahrensschritten eine metallische Kontaktstruktur auf die Dotierseite des Halbleitersubstrates aufgebracht wird.

13. Verfähren nach einem der vorangegangenen Ansprüche,
**dadurch gekennzeichnet,**
**dass** in Verfahrensschritt B das lokale Aufschmelzen mittels lokaler Erhitzung durch einen Laser erfolgt und/oder
**dass** in Verfahrensschritt B zum lokalen Aufschmelzen des Halbleitersubstrates eine Erwärmung auf mindestens 1410°C erfolgt.

14. Verfahren nach einem der vorangegangenen Ansprüche,
**dadurch gekennzeichnet,**
**dass** in den Verfahrensschritten B und C die Dotierbereiche derart erzeugt werden, dass der Niedrigdotierbereich (4) die Dotierseite des Halbleitersubstrates vollständig bedeckt und eine Vielzahl von Hochdotierungsbereichen aufweist.

## Claims

1. Method for creating a selective doping structure in a semiconductor substrate (1) for the production of a photovoltaic solar cell, the selective doping structure being formed at least on a doping side of the semiconductor substrate, wherein on the doping side at least one planar low-doping region (4) of a first doping profile is created in the semiconductor substrate (1) and at least one local high-doping region (3) of a second doping profile is created within the first low-doping region,
the low-doping region (4) and the high-doping region (3) being formed with the same doping type, and the high-doping region having a lower cross-conduction resistance than the low-doping region (4), wherein the method comprises the following method steps:
A application of a dopant-containing doping layer (2) to the doping side of the semiconductor substrate,
B local heating of a melt region of the doping layer (2) and of a melt region of the semiconductor substrate, which melt region is located below the doping layer (2), in such a way that in a local region there is briefly formed a molten mixture of at least the melt region of the doping layer (2) and the melt region of the semi-conductor substrate, wherein dopant diffuses from the doping layer (2) into the molten semiconductor substrate (1) by means of liquid-liquid diffusion so that after the molten mixture has solidified the high-doping region is created,
C creation of the planar low-doping region (4) by global heating of the semiconductor substrate (1) in such a way that dopant diffuses from the doping layer (2) into the semiconductor substrate (1),
D removal of the doping layer (2),
**characterised in that**
the method further comprises the following method step:
E removal of a layer of the semiconductor substrate on the doping side in such a way that, in a method step E1, a portion of the low-doping region (4) and of the high-doping region (3) that is close to the surface is removed,
the method steps being carried out in the sequence A, B, C, D, E or A, C, B, D, E, with or without interposition of further intermediate steps,
the method steps A to E are carried out without interposition of masking steps and
in method step E a layer having a thickness in the range of from 50 nm to 200 nm is removed.

2. Method according to claim 1,
**characterised in that**
in the method sequence A, C, B, D, E, method steps A and C are carried out directly one after the other, or method steps A and C are carried out simultaneously.

3. Method according to either one of the preceding claims,
**characterised in that**
in method step E, a layer having a specified thickness in the range of from 50 nm to 200 nm is removed so that the surface doping concentration of the low-doping region (4) on the doping side is less than 4x10²⁰ cm⁻³, preferably less than 2x10²⁰ cm⁻³, especially preferably less than 1x10²⁰ cm⁻³, more preferably less than 5x10¹⁹ cm⁻³.

4. Method according to any one of the preceding claims,
**characterised in that**
the high-doping region (3) has a surface doping concentration that is the same as or higher than the low-doping region (4).

5. Method according to any one of the preceding claims,
**characterised in that**
the doping layer (2) has a thickness of between 10 nm and 1 µm, preferably between 10 nm and 500 nm, more preferably between 10 nm and 100 nm.

6. Method according to any one of the preceding claims,
**characterised in that**
the doping layer (2) is applied so as to contain dopant in a concentration of at least 1 % by weight, preferably at least 4 % by weight, more preferably in the range of from 6 % by weight to 10 % by weight.

7. Method according to any one of the preceding claims,
**characterised in that**
in a method step F, a protective layer is applied to the doping side of the semiconductor substrate, preferably a plurality of protective layers.

8. Method according to any one of the preceding claims,
**characterised in that**
in method step A, the doping layer (2) is applied so as to cover the entire doping side of the semiconductor substrate.

9. Method according to any one of the preceding claims,
**characterised in that**
in method step E1, the layer is removed by means of wet chemical etching, preferably by means of hydrofluoric acid (HF), especially by means of a mixture of hydrofluoric acid (HF), nitric acid (HNO₃), acetic acid (CH₃COOH) and water (H₂O), and subsequent removal of the resulting layer by means of potassium hydroxide.

10. Method according to any one of the preceding claims,
**characterised in that**
in method step E, the removal is effected in such a way that a layer conversion takes place by means of thermal oxidation or by means of chemical oxidation and
the converted layer is then removed, preferably by a wet chemical etching process, especially by means of hydrofluoric acid (HF).

11. Method according to any one of the preceding claims,
**characterised in that**
in method step B, the local melting is effected in a substantially linear region.

12. Method according to any one of the preceding claims,
**characterised in that**
the high-doping region is formed so as to cover those regions of the doping side in which, in subsequent method steps, a metallic contact structure is applied to the doping side of the semiconductor substrate.

13. Method according to any one of the preceding claims,
**characterised in that**
in method step B, the local melting is effected by means of local heating by a laser and/or
in method step B, for local melting of the semiconductor substrate, heating to at least 1410°C is effected.

14. Method according to any one of the preceding claims,
**characterised in that**
in method steps B and C, the doping regions are created in such a way that the low-doping region (4) completely covers the doping side of the semiconductor substrate and has a multiplicity of high-doping regions.

## Revendications

1. Procédé pour produire une structure de dopage sélective dans un substrat semi-conducteur (1) pour la fabrication d'une cellule solaire photovoltaïque, la structure de dopage sélective étant formée au moins sur un côté de dopage du substrat semi-conducteur, au moins une zone faiblement dopée (4) plane ayant un premier profil de dopage étant produite sur le côté de dopage dans le substrat semi-conducteur (1), et au moins une zone fortement dopée (3) locale ayant un deuxième profil de dopage étant produite à l'intérieur de la première zone faiblement dopée,
la zone faiblement dopée (4) et la zone fortement dopée (3) étant réalisées avec le même type de dopage et la zone fortement dopée présente une résistivité transversale inférieure à celle de la zone faiblement dopée (4),
le procédé comprenant les étapes suivantes :
A application d'une couche de dopage (2) contenant une substance de dopage sur le côté de dopage du substrat semi-conducteur,
B chauffage local d'une zone de fusion de la couche de dopage (2) et d'une zone de fusion du substrat semi-conducteur située au-dessous de la couche de dopage (2), de telle sorte qu'un mélange de fusion entre au moins la zone de fusion de la couche de dopage (2) et la zone de fusion du substrat semi-conducteur se forme temporairement dans une zone locale, la substance de dopage se diffusant, par diffusion liquide-liquide, de la couche de dopage (2) dans le substrat semi-conducteur (1) fondu, de telle sorte qu'après durcissement du mélange de fusion, la zone fortement dopée (3) soit produite,
C production de la zone faiblement dopée (4) plane en chauffant le substrat semi-conducteur (1) dans sa globalité de telle sorte que la substance de dopage se diffuse de la couche de dopage (2) dans le substrat semi-conducteur (1),
D élimination de la couche de dopage (2),
**caractérisé en ce**
**que** le procédé comprend en outre l'étape suivante :
E élimination d'une couche du substrat semi-conducteur sur le côté de dopage, de telle sorte que dans une étape E1 du procédé, une partie proche de la surface de la zone faiblement dopée (4) et de la zone fortement dopée (3) soit éliminée,
les étapes du procédé étant exécutées selon la séquence A, B, C, D, E ou A, C, B, D, E, avec ou sans intercalation d'autres étapes intermédiaires,
**que** les étapes du procédé A à E sont exécutées sans intercalation d'étapes de masquage et
**que** dans l'étape du procédé E, une couche d'une épaisseur se situant dans la plage de 50 nm à 200 nm est éliminée.

2. Procédé selon la revendication 1,
**caractérisé en ce**
**que** dans la séquence du procédé A, C, B, D, E, les étapes du procédé A et C sont exécutées directement l'une après l'autre ou que les étapes du procédé A et C sont exécutées en même temps.

3. Procédé selon l'une des revendications précédentes,
**caractérisé en ce**
**que** dans l'étape du procédé E, une couche d'une épaisseur prédéfinie se situant dans la plage de 50 nm à 200 nm est enlevée, de telle sorte que la concentration de dopage à la surface de la zone faiblement dopée (4) sur le côté de dopage soit inférieure à 4x10²⁰ cm⁻³, de préférence inférieure à 2x10²⁰ cm⁻³, particulièrement de préférence inférieure à 1x10²⁰ cm⁻³, tout particulièrement de préférence inférieure à 5x10¹⁹ cm⁻³.

4. Procédé selon l'une des revendications précédentes,
**caractérisé en ce**
**que** la zone fortement dopée (3) présente une concentration de dopage à la surface égale ou supérieure à celle de la zone faiblement dopée (4).

5. Procédé selon l'une des revendications précédentes,
**caractérisé en ce**
**que** la couche de dopage (2) présente une épaisseur comprise entre 10 nm et 1 µm, de préférence entre 10 nm et 500 nm, particulièrement de préférence entre 10 nm et 100 nm.

6. Procédé selon l'une des revendications précédentes,
**caractérisé en ce**
**que** la couche de dopage (2) appliquée contient la substance de dopage dans une concentration d'au moins 1 pour cent en poids, de préférence au moins 4 pour cent en poids, particulièrement de préférence se situant dans la plage de 6 pour cent en poids à 10 pour cent en poids.

7. Procédé selon l'une des revendications précédentes,
**caractérisé en ce**
**que** dans une étape du procédé F, une couche de protection, de préférence plusieurs couches de protection, est/sont appliquée(s) sur le côté de dopage du substrat semi-conducteur.

8. Procédé selon l'une des revendications précédentes,
**caractérisé en ce**
**que** dans l'étape du procédé A, la couche de dopage (2) est appliquée de manière à recouvrir tout le côté de dopage du substrat semi-conducteur.

9. Procédé selon l'une des revendications précédentes,
**caractérisé en ce**
**que** dans l'étape du procédé E1, la couche est éliminée par gravure chimique humide, de préférence au moyen d'acide fluorhydrique (HF), en particulier au moyen d'un mélange d'acide fluorhydrique (HF), d'acide nitrique (HNO₃), d'acide acétique (CH₃COOH) et d'eau (H₂O), suivie de l'élimination de la couche qui se forme au moyen d'hydroxyde de potassium.

10. Procédé selon l'une des revendications précédentes,
**caractérisé en ce**
**que** dans l'étape du procédé E, l'élimination est effectuée de telle sorte qu'une conversion de couche soit effectuée par oxydation thermique ou par oxydation chimique et
**que** la couche convertie est ensuite enlevée, de préférence par un procédé de gravure chimique humide, en particulier au moyen d'acide fluorhydrique (HF).

11. Procédé selon l'une des revendications précédentes,
**caractérisé en ce**
**que** dans l'étape du procédé B, la fusion locale a lieu dans une zone sensiblement linéaire.

12. Procédé selon l'une des revendications précédentes,
**caractérisé en ce**
**que** la zone fortement dopée est formée de manière à recouvrir les zones du côté de dopage sur lesquelles, dans des étapes ultérieures du procédé, une structure de contact métallique est appliquée sur le côté de dopage du substrat semi-conducteur.

13. Procédé selon l'une des revendications précédentes,
**caractérisé en ce**
**que** dans l'étape du procédé B, la fusion locale est effectuée par échauffement local par un laser et/ou
**que** dans l'étape du procédé B, un échauffement à au moins 1410°C est effectué pour la fusion locale du substrat semi-conducteur.

14. Procédé selon l'une des revendications précédentes,
**caractérisé en ce**
**que** dans les étapes du procédé B et C, les zones de dopage sont produites de telle sorte que la zone faiblement dopée (4) recouvre entièrement le côté de dopage du substrat semi-conducteur et présente une pluralité de zones fortement dopées.
